# EUROPEAN PATENT APPLICATION

(11) **EP 1 598 859 A1**
(43) Date of publication of application: **23.11.2005**
(21) Application number: 04713215.4
(22) Date of filing: 20.02.2004
(51) Int. Cl.: H01L 21/314, H01L 21/302, H01L 29/78

(54) **SUBSTRATE PROCESSING METHOD**

(30) Priority: 28.02.2003 JP 2003054242
(71) Applicant: TOKYO ELECTRON LIMITED, Minato-ku, Tokyo 107-8481 (JP)
(72) Inventor: NAKANISHI, Toshio c/o Tokyo Electron Limited,, ki-shi, Hyogo 6600891 (JP); OZAKI, Shigenori c/o Tokyo Electron Limited,, ki-shi, Hyogo, 6600891 (JP); SASAKI, Masaru c/o Tokyo Electron Limited,, ki-shi, Hyogo, 6600891 (JP)
(74) Representative: HOFFMANN EITLE
(86) International application number: PCT/JP2004/002013
(87) International publication number: WO 2004/077542

(57) **Abstract**

A substrate processing method includes a first step of exposing a silicon substrate surface to mixed gas plasma of an inert gas and hydrogen, and a second step of conducting any of oxidation processing, nitridation processing and oxynitridation processing to said silicon substrate surface by plasma processing after said first step, wherein an organic substance remaining on said substrate surface is removed in said first step.

## Description

### TECHNICAL FIELD

The present invention generally relates to substrate processing technology, and more particularly to a substrate processing method for forming an insulation film on a silicon substrate.

In semiconductor production technology, formation of insulation film on a silicon substrate is most fundamental and yet important technology. Especially, a very high quality insulation film is required for the gate insulation film, or the like, of MOS transistors. Meanwhile, the film thickness of the gate insulation film has been decreased to about 1nm with device miniaturization with recent ultra-miniaturized high-speed semiconductor devices, and there is a need for the technology capable of forming such a thin insulation film with high quality.

### BACKGROUND ART

Conventionally, high quality silicon oxide films used for the gate insulation film of a MOS transistor have been formed by thermal oxidation processing of a silicon substrate surface. A thermal oxide film of silicon thus formed has the feature of small number of dangling bonds, and there is caused little trapping of carriers even in the case the film is used for an insulation film covering the channel region and thus used in the environment in which the film is subjected to high electric field. Thereby, stable threshold characteristics are realized.

On the other hand, with the progress in the miniaturization technology, it is now becoming possible these days to produce ultra-miniaturized semiconductor devices having a gate length of 0.1µm or less.

In order to improve the operational speed of semiconductor device with such ultra miniaturized semiconductor devices by way of reducing the gate length, there is a need of reducing the thickness of the gate insulation film in accordance with scaling law. In the case of a MOS transistor having the gate length of 0,1µm, for example, there is a need of reducing the thickness of the gate insulation film to 2nm or less. On the other hand, when the film thickness is decreased like this with a conventional thermal oxide film, there occurs an increase of gate leakage current in the form of tunneling current. From this reason, it has been thought that film thickness of 2nm would be the limit of gate insulation film formed by a thermal oxide film. With a thermal oxide film having the film thickness of 2nm, a gate leakage current of 1×10⁻²A/cm² has been realized.

Contrary to this, there is proposed a technology capable of forming a higher quality silicon oxide film by conducting oxidation processing to a silicon substrate, by using microwave plasma.

With the silicon oxide film thus formed by microwave plasma oxidation of silicon substrate, it has been confirmed that leakage current of 1×10⁻²A/cm² is possible with the application voltage of 1V, even in the case the film has a film thickness of 1.5nm. Thus, it is expected that the silicon oxide film formed by microwave plasma enables breaking through of the foregoing limit of device miniaturization encountered in the conventional semiconductor devices that use a conventional thermal oxide film. Further, with the substrate processing that uses the microwave plasma, it becomes possible to form an oxynitride film or nitride having a large specific dielectric constant on a silicon substrate with the film quality exceeding the film quality of a thermal oxide film. In the case of using an oxynitride film for gate insulation film, a leakage current of 1×10⁻²A/cm² or less is realized at the application voltage of 1V for an oxynitride film having a film thickness equivalent to the film thickness of 1nm of silicon oxide film.

Substrate processing by microwave plasma can be performed at a low temperature typically below 500°C, and because of this, it becomes possible to reduce the time needed for raising and lowering the substrate temperature. Thereby, it becomes possible to produce the semiconductor device with large throughput. Further, with such low temperature processing, there occurs no change of impurity concentration profile of diffusion regions even when the diffusion regions are already formed in the substrate, and it becomes possible to realize desired device characteristics with reliability.

Meanwhile, a gate insulation film is required to provide the feature of small leakage current and high reliability.

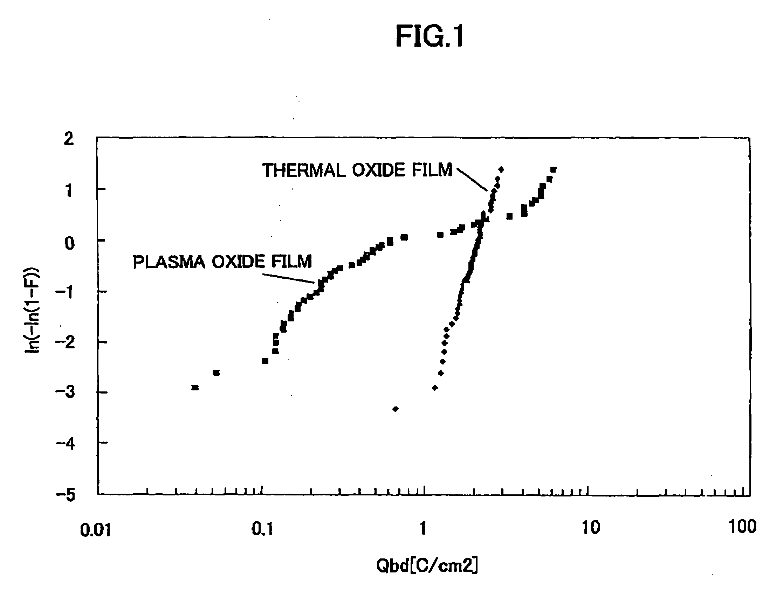

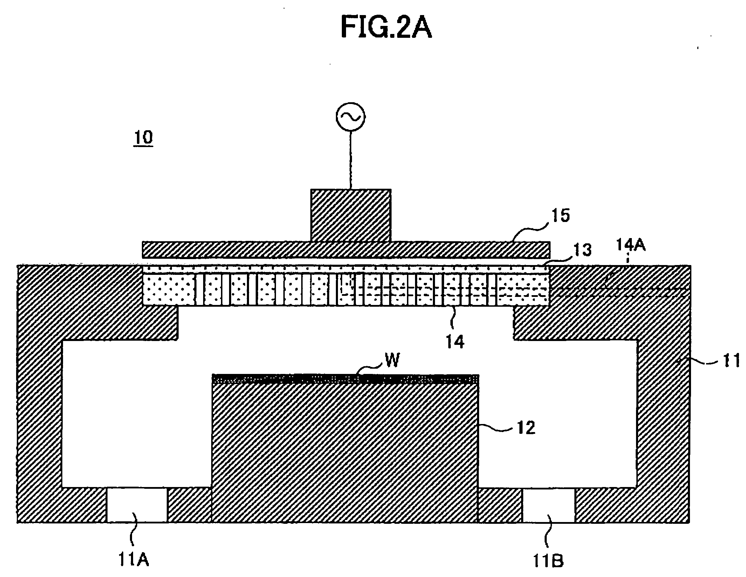

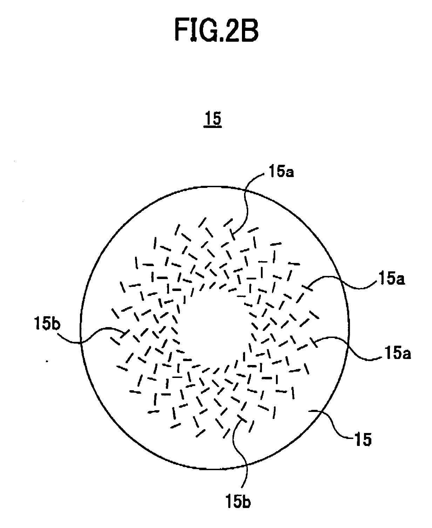

Figure 1 shows the relationship between the accumulated defect rate F and integral electric charge amount (Qbd) leading to breakdown (TDDB characteristic) for a silicon oxide film formed on a silicon substrate surface with the thickness of 10nm by a microwave plasma oxidation processing conducted by the inventor of the present invention (shown in the drawing as "plasma oxide film"), in comparison with a thermal oxide film of the same thickness, wherein the vertical axis represents the accumulated defect rate F while the horizontal axis represents the integral electric charge amount Qbd that leads to insulation breakdown. It should be noted that the plasma oxide film has been formed by using a microwave plasma substrate processing apparatus to be explained later with Figure 2, by oxidizing the silicon substrate surface already applied with removal process of native oxide film in the mixed gas plasma of argon and oxygen at the substrate temperature of 400°C.

Referring to Figure 1, the line representing the accumulated defect rate F forms a steep gradient with regard to the integral electric charge amount Qdb in the case of the thermal oxide film, and thus, insulation breakdown occurs when the integral electric charge amount Qdb has reached a predetermined value. Such an insulation film has excellent reliability characterized predictable lifetime.

In the case of the plasma oxide film, on the other hand, the slope of the line representing the accumulated defect rate F is small, indicating that breakdown of the insulation film occurs with various values of the integrated electric charge amount. With such an insulation film, it is not possible to predict the device lifetime with certainty and no reliability is attained for the semiconductor device.

### DISCLOSURE OF THE INVENTION

Accordingly, it is a general object of the present invention to provide a novel and useful substrate processing method wherein the foregoing problems are eliminated.

Another and more specific object of the present invention is to provide a substrate processing method capable of forming an oxide film, a nitride film, or an oxynitride film on a silicon substrate surface by oxidation processing, nitridation processing or oxynitridation processing conducted in plasma with improved reliability and thus capable of assuring long device lifetime with the semiconductor device that uses such an insulation film.

Another object of the present invention is to provide a substrate processing method, comprising:
a first step of exposing a silicon substrate surface to mixed gas plasma of an inert gas and hydrogen; and
a second step of conducting any of oxidation processing, nitridation processing and oxynitridation processing to said silicon substrate surface by plasma processing after said first step.

According to the present invention, organic substance remaining on the substrate surface, is removed effectively by exposing the silicon substrate surface to the mixture gas plasma of the inert gas and the hydrogen gas before the substrate processing by plasma, and it becomes possible to form a very high-quality insulation film on a fresh silicon surface.

Other objects and further features of the present invention will become apparent from the detailed explanation of invention hereinafter when read in conjunction with the attached drawings.

### BRIEF DESCRIPTION OF THE DRAWING

Figure 1 is a diagram showing the TDDB characteristic of a conventional thermal oxide film and a plasma oxide film;
Figures 2A and 2B are diagrams showing the construction of a plasma processing apparatus used with the present invention;
Figures 3A and 3B are diagrams showing the substrate processing according to a first embodiment of the present invention;
Figure 4 is a diagram showing the TDDB characteristic of a plasma oxide film obtained with the first embodiment of the present invention;
Figure 5 is a diagram showing the leakage current characteristic of the plasma oxide film obtained according to the first embodiment of the present invention;
Figure 6A and 6B are diagrams showing the substrate processing according to a second embodiment of the present invention.

### BEST MODE FOR IMPLEMENTING THE INVENTION

### [FIRST EMBODIMENT]

The inventor of the present invention has acquired the knowledge, in an experimental investigation on the formation process of oxide films, nitride films and oxynitride films on a silicon substrate by microwave plasma processing, suggesting that organic substance remaining on the silicon substrate surface exerts a significant effect on the reliability of insulation film formed on the substrate.

Figures 2A and 2B schematically show the construction a microwave plasma substrate processing apparatus 10 used by the inventor of the present invention.

Referring to Figure 2A, the microwave plasma substrate processing apparatus 10 includes a processing vessel 11 accommodating therein a stage 12 for holding a substrate W to be processed, wherein the processing vessel 11 is evacuated at evacuation ports 11A and 11B.

Further, an opening is formed in the processing vessel 11 in correspondence to the substrate W to be processed on the stage 12, wherein the opening is closed by a cover plate 13 of a low loss ceramic such as quartz, alumina, or the like, and there is formed underneath the cover plate 13 a shower plate 14 of low loss ceramic such as quartz, alumina, or the like, so as to face the substrate W to be processed, wherein the shower plate 14 is formed with a large number of nozzle openings communicating with a gas inlet path 14A.

The shower plate 14 and the cover plate 13 form a microwave window, and a microwave antenna 15 such as a radial line slot antenna, horn antenna, or the like, is formed outside the cover plate 13.

In operation, the processing space inside the processing vessel 11 is set to a predetermined processing pressure by evacuating through the evacuation ports 11A and 11B, and an oxidation gas or a nitridation gas is introduced from the shower plate 14 together with an inert gas such as argon, Kr, or the like.

Figure 2B is a diagram showing the construction of the radial line slot antenna 15.

Referring to Figure 2B, the radial line slot antenna 15 includes a flat, disk-like antenna main body connected to an external microwave source via a coaxial waveguide, or the like, wherein there is provided a radiation plate 15A at the mouth of the antenna main body such that the radiation plate 15A is formed with a large number of slots 15a and a large number of slots 15b intersecting perpendicularly thereto as shown in Figure 2B. Further, a retardation plate (not shown) of dielectric plate of constant thickness is interposed between the between the antenna main body and the radiation plate 15A.

Further, by introducing a microwave of several GHz from the antenna 15, high density microwave plasma is excited in the processing vessel 11 at the surface of the substrate W to be processed. By exciting the plasma with microwave, the plasma has a low electron temperature with the substrate processing apparatus of Figure 1, and it is possible to avoid damaging of the substrate W to be processed or the inner wall of the processing vessel 11. Further, the radicals thus formed are caused to flow along the surface of the substrate W to be processed and are evacuated promptly, and thus, recombination of the radicals is suppressed, and it becomes possible to achieve highly uniform substrate processing efficiently at a low temperature of 550°C or less.

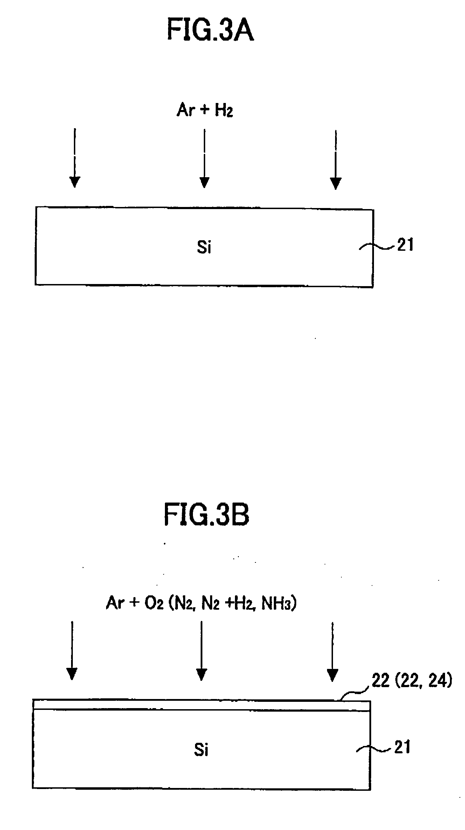

Figures 3A - 3C are diagrams showing the substrate processing conducted by the inventor of the present invention in the investigation constituting the foundation of the present invention and corresponding to a first embodiment of the present invention, while using substrate processing apparatus 10 of Figure 1.

Referring to Figure 3A, a silicon substrate 21, from which the native oxide film is removed by HF treatment, is introduced to the processing vessel 11 of the substrate processing apparatus 10 as the substrate W to be processed, and a mixed gas of argon and hydrogen is introduced from the shower plate 14. Further, plasma is formed by exciting the mixed gas by a microwave.

In an example, the process pressure inside the processing vessel 11 is set to 7Pa, and an argon gas and a hydrogen gas are supplied with respective flow rates 1000SCCM and 40SCCM. Further, a microwave of 2.4GHz in frequency is supplied to the microwave antenna 15 with the power of 1500W at the substrate temperature of 400°C, and high density plasma is formed in the vicinity of the surface of the substrate W to be processed.

With the step of Figure 3A, an organic substance remaining on the substrate surface is removed effectively in the form of hydrocarbons as a result of exposing the surface of the silicon substrate 21 to the plasma thus formed, even at a low substrate temperature of 400°C, and a fresh silicon surface is exposed at the substrate surface.

Next, in the step of Figure 3B, a silicon oxide film 22 is formed on the silicon substrate 21 thus applied with the processing of Figure 3A with the thickness of 10 - 1nm, by setting the processing pressure inside the processing vessel 11 to typically 7Pa and supplying an argon gas and an oxygen gas with respective flow rates of 1000SCCM and 40SCCM, while setting the substrate temperature to 400°C and by supplying the microwave of 2.4GH frequency to the microwave antenna 15 with the power of 1500W.

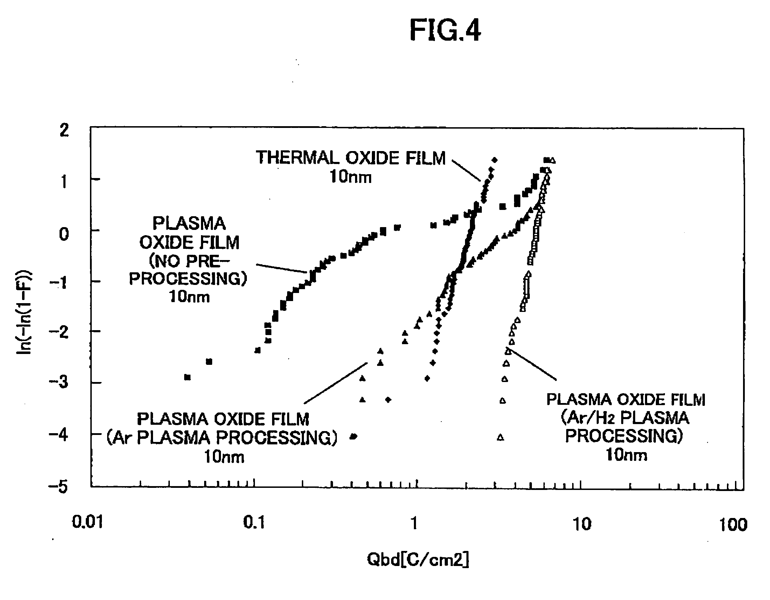

Figure 4 shows the relationship between the accumulated defect rate F and the breakdown electric charge amount Qdb (TDDB) for the silicon oxide film thus obtained in comparison with the result of Figure 1. Further, Figure 4 also shows the result for the case in which the silicon substrate 21 is exposed to the argon plasma in the step of Figure 3A. In Figure 4, the silicon oxide film is formed to the thickness of 10nm.

Referring to Figure 4, it should be noted that the process in which the pre-processing of Figure 3A is omitted, and thus, the silicon oxide film 22 is formed on the silicon substrate 21 directly with the thickness of 10nm, corresponds to the plasma oxide film explained previously with reference to Figure 1, wherein it will be noted that there appears a large variation of breakdown electric charge amount Qdb as explained already with reference to Figure 1.

Contrary to this, in the case the argon plasma processing is conducted in the pre-processing step of Figure 3A, it can be seen that variation of the breakdown electric charge amount Qdb is decreased. Particularly, in the case the pre pre-processing is conducted in the mixed gas plasma of argon and hydrogen as shown in Figure 3A, the variation of the breakdown electric charge mount Qdb is decreased further, and a result comparable to the case of a thermal oxide film is attained. Thus, by carrying out the pre-processing process of Figure 3A in the mixture gas plasma of argon and hydrogen, it can be seen that a plasma oxide film having the reliability comparable to that of a thermal oxide film is obtained.

Moreover, as can be seen from Figure 4, the absolute value of the breakdown electric charge amount Qbd of the plasma oxide film of the present embodiment is increased further as compared with the case of thermal oxide film, indicating that the lifetime of the obtained plasma oxide film is increased.

The fact shown in Figures 1 and 4 that the variation of the breakdown electric charge amount Qbd is small in the thermal oxide film formed in the oxidizing ambient at high temperatures and that the breakdown electric charge amount Qbd is large in the plasma oxide film formed at the low temperature of about 400°C, suggests that this phenomenon is related to organic substances remaining on the surface of the silicon substrate 21. In the present embodiment, it is thought that, as a result of the processing of the surface of the silicon substrate 21 in the mixed gas plasma of argon and hydrogen in the step of Figure 3A, the organic substance remaining on the silicon substrate surface is removed therefrom in the form of hydrocarbons, and a fresh silicon surface is exposed at the silicon substrate at the commencement of the step of Figure 3B.

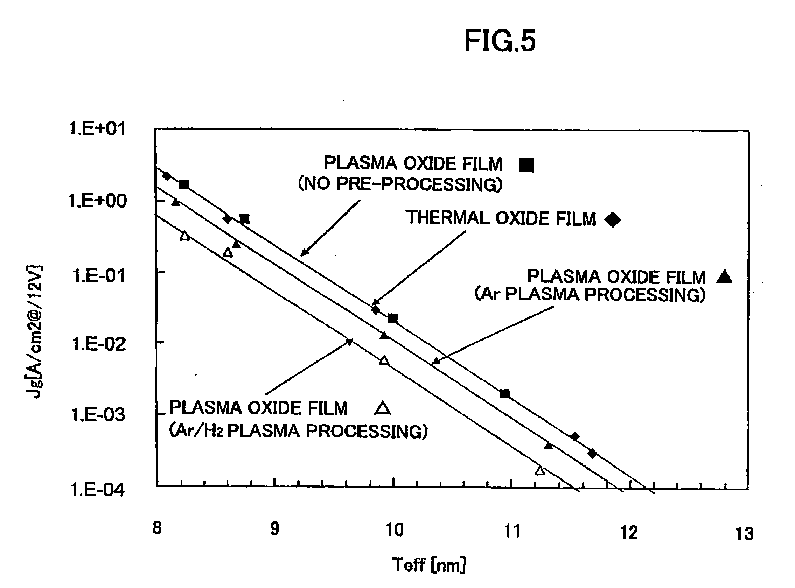

Figure 5 shows the leakage current characteristics of the silicon oxide film 22 thus formed with the film thickness of 10nm, wherein the measurement of Figure 5 is conducted under the condition of applying a voltage of 12V, and thus, the values are different from the case explained previously in which the measurement was made by applying a voltage of 1V.

Referring to Figure 5, with the plasma oxide film shown in Figure 1 in which the pre-processing step of Figure 3A is omitted, a leakage current density comparable with that of a conventional thermal oxide film is obtained, while in the case in which the plasma pre-processing by argon gas is conducted in the step of Figure 3A, there is caused a decrease of leakage current, particularly in the case the pre-processing process of Figure 3A is conducted in the mixed gas plasma of argon and hydrogen.

Further, while formation of silicon oxide film has been made in the present embodiment on the surface of the silicon substrate 21 in the step of Figure 3B by the mixed gas plasma of argon and hydrogen, it is also possible to form a silicon nitride film 23 by using argon and nitrogen, or argon and ammonia, or argon and a mixed gas of nitrogen and hydrogen. Further, it is also possible to form a silicon oxynitride film 24 by using argon and nitrogen and oxygen, or argon and ammonia and oxygen, or argon and a mixed gas of nitrogen and hydrogen and oxygen.

Further, it is also possible to use an inert gas of other rare gas such as helium, krypton and xenon, in place of argon with the present embodiment.

Further, it is possible with the present embodiment to use other oxidizing gas or nitriding gas such as NO, N₂O, H₂O, or the like in the present invention, in place of the oxygen gas, nitrogen gas and ammonia gas.

### [Second EMBODIMENT]

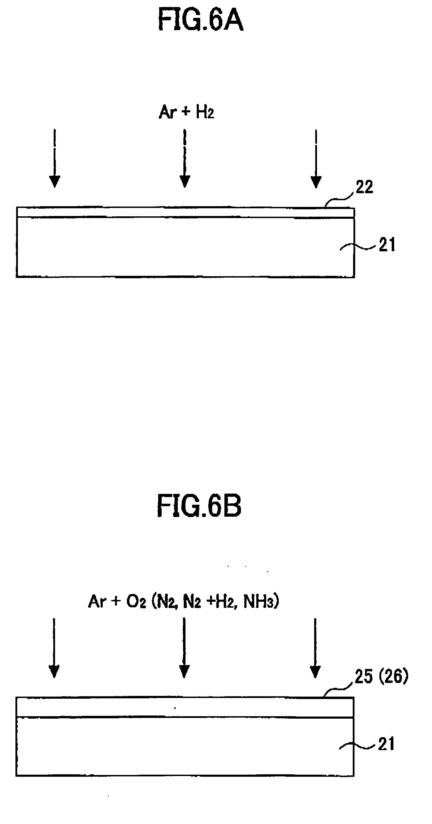

Figures 6A and 6B show the substrate processing method according to a second embodiment of the present invention.

Referring to Figure 6A, there is formed a silicon oxide film 22 on a silicon substrate 21 by the process of Figures 3A and 3B explained before or by other process, wherein the surface of the silicon oxide film 22 is processed by the mixture gas plasma of argon and hydrogen under the condition similar to the process of Figure 3A, and the organic substance remaining on the surface of the silicon oxide film 22 is removed.

Next, in the step of Figure 6B, there is caused a growth of the oxide film on the silicon oxide film 22 thus processed by applying the mixed gas plasma of argon and oxygen under the similar condition as Figure 3B, and with this, there is formed an oxide film 25.

It should be noted that the oxide film 25 thus formed has excellent reliability and leakage current density similarly to the plasma oxide film that explained with the previous embodiment.

Further, in the process of Figure 6B, it is possible to form a silicon oxynitride film 26 by nitriding the silicon oxide film 22 by using argon and nitrogen, or argon and ammonia, or the mixed gas plasma of argon and nitrogen and hydrogen.

Further, while explanation has been made for the present embodiment for the case of using the microwave plasma substrate processing apparatus of Figures 2A and 2B that uses the radial line slot antenna 15, it is also possible to omit the shower plate 14 in the construction of Figure 2A and introduce the gases from the gas inlet part 14A directly into the processing vessel 11. Further, the present invention is not limited to such a particular substrate processing apparatus, but is effective also in a parallel plate plasma processing apparatus, an ICP plasma processing apparatuses, an ECR plasma processing apparatus, and the like.

Further, while the present invention has been explained heretofore with regard to preferred embodiments, the present invention is not limited to such a particular embodiment but various variations and modifications may be made within the subject matter recited in claims.

## Claims

1. A substrate processing method, comprising:
a first step of exposing a silicon substrate surface to mixed gas plasma of an inert gas and hydrogen; and
a second step of conducting any of oxidation processing, nitridation processing and oxynitridation processing to said silicon substrate surface by plasma processing after said first step.

2. The substrate processing method as claimed in claim 1, wherein said inert gas is a rare gas.

3. The substrate processing method as claimed in claim 1, wherein said inert gas comprises any of krypton and xenon.

4. The substrate processing method as claimed in claim 1, wherein said firs step and said second step are conducted consecutively in the same plasma processing apparatus .

5. The substrate processing method as claimed in claim 1, wherein said mixed gas plasma of said inert gas and hydrogen is excited in said first step by a microwave.

6. The substrate processing method as claimed in claim 1, wherein, in said second step, said plasma processing is conducted by using plasma excited by a microwave.

7. The substrate processing method as claimed in claim 1, wherein said plasma is excited by a microwave emitted from a radial line slot antenna.

8. The substrate processing method as claimed in claim 1, wherein, in said first step, a silicon surface is exposed at a surface of said silicon substrate.

9. The substrate processing method as claimed in claim 1, wherein, in said first step, there is formed an insulation film on a surface of said silicon substrate.

10. The substrate processing method as claimed in claim 9, wherein said insulation film comprises a silicon oxide film.
